# EUROPEAN PATENT APPLICATION

(11) **EP 4 672 333 A1**
(43) Date of publication of application: **31.12.2025**
(21) Application number: 24777560.4
(22) Date of filing: 20.02.2024
(51) Int. Cl.: H01L 23/498, H01L 23/538

(54) **CHIP METALLIZATION METHOD AND CHIP**

(30) Priority: 30.03.2023 CN 202310363203
(71) Applicant: Huawei Technologies Co., Ltd., Shenzhen, Guangdong 518129 (CN)
(72) Inventor: LIU, Yi, Shenzhen, Guangdong 518129 (CN); LIU, Jie, Shenzhen, Guangdong 518129 (CN); ZHU, Jifeng, Shenzhen, Guangdong 518129 (CN)
(74) Representative: Grünecker Patent- und Rechtsanwälte PartG mbB
(86) International application number: PCT/CN2024/077665
(87) International publication number: WO 2024/198767

(57) **Abstract**

This application provides a chip metallization method and a chip. In this application, a dielectric layer does not need to be deposited, and a substrate can be directly etched. In other words, etching is performed in a chip substrate, so that a subsequently deposited metal thin film can be embedded into the chip substrate. Because the chip substrate is usually thick, a thickness of the metal thin film may be flexibly controlled by controlling a thickness of the dielectric layer and a thickness of a barrier layer that are subsequently deposited, so that the thickness of the metal thin film can be increased, and the thickness of the dielectric layer can be reduced as much as possible. This avoids impact of an excessively thick dielectric layer on chip performance, and improves power supply performance of the chip.

## Description

This application claims priority to Chinese Patent Application No. 202310363203.6, filed with the China National Intellectual Property Administration on March 30, 2023 and entitled "CHIP METALLIZATION METHOD AND CHIP", which is incorporated herein by reference in its entirety.

### TECHNICAL FIELD

Embodiments of this application relate to the field of semiconductor integrated circuit chip processes, and more specifically, to a chip metallization method and a chip.

### BACKGROUND

"Chip metallization" refers to a process in which a conductive metal thin film is deposited on an insulation dielectric thin film in a chip manufacturing process, and interconnected metal routings and an integrated circuit are formed by using a photoetching process and an etching process. The metal routing is used for signal transmission in the integrated circuit, and a dielectric layer ensures a signal not to be affected by adjacent metal routings. A chip metallization process directly affects signal transmission and a power supply capability of the chip. To improve chip performance, it is expected that a metal layer of the chip can be thicker.

Generally, for metallization of a back surface of a chip substrate, the deposited dielectric layer is etched, and then the metal thin film is deposited. It may also be understood that a thickness of the metal thin film is positively correlated with a thickness of the dielectric layer. Consequently, a deposited metal may be embedded in the dielectric layer. Therefore, if the thickness of the metal layer of the chip needs to be increased, the thickness of the dielectric layer needs to be increased. However, if the dielectric layer is excessively thick, a large thin film stress is generated, causing a wafer to warp. This increases difficulty of a subsequent chip process, and in some cases, the entire chip may be damaged.

Therefore, there is a need for a chip metallization method, to increase a thickness of a metal layer on a back surface of a chip substrate, and reduce impact of a thickness of a dielectric layer on chip performance.

### SUMMARY

This application provides a chip metallization method, to increase a thickness of a metal layer on a back surface of a chip substrate, reduce impact of a thickness of a dielectric layer on chip performance, and improve power supply performance of a chip.

According to a first aspect, a structure of a chip is provided, where the chip includes: a chip substrate, a first thin film, a second thin film, and a third thin film, where a back surface of the chip substrate is etched, a thickness of the chip substrate is a first thickness, and an etching depth is less than the first thickness; the first thin film is deposited on the back surface of the etched chip substrate, and the first thin film is a dielectric material; the second thin film is deposited on the first thin film, and the second thin film is a barrier layer material; and the third thin film is deposited on the second thin film, the third thin film is a metal material, and the third thin film is embedded into the chip substrate.

Based on the foregoing technical solution, in this application, the dielectric layer does not need to be deposited, and the substrate on the back surface of the chip may be directly etched, so that the first thin film, the second thin film, and the third thin film that are subsequently deposited may all be embedded into the chip substrate, where the third thin film is the metal material. In other words, in this application, etching is performed in the chip substrate. Because the chip substrate is usually thick, a thickness of the third thin film may be flexibly controlled by controlling thicknesses of the first thin film and the second thin film. In this way, a thickness of a metal layer can be increased, and a thickness of the dielectric layer can be reduced as much as possible. According to the solutions of this application, impact of an excessively thick dielectric layer on chip performance can be reduced, power supply performance of the chip can be improved, and overall performance of the chip is improved.

In addition, a thermal conductivity of metal in the chip is usually higher than that of the chip substrate, and a metal electrode may be considered as a heat source. In this application, the metal electrode may be embedded into the chip substrate, so that a heat dissipation capability of the chip can be improved. In addition, in this application, impact of the thickness of the dielectric layer on chip performance is further avoided, so that a thickness of the entire chip can be reduced, subsequent packaging of the chip is facilitated, and difficulty of a subsequent process of the chip can be reduced.

In a possible implementation, a fourth thin film is deposited on the back surface of the chip substrate, the fourth thin film is the dielectric material, and a thickness of the fourth thin film is a second thickness; that the back surface of the chip substrate is etched includes: the chip substrate on which the fourth thin film is deposited is etched; and that the first thin film is deposited on the back surface of the etched chip substrate includes: the first thin film is deposited on the back surface that is of the etched chip substrate and on which the fourth thin film is deposited, where the etching depth is greater than the second thickness and less than a third thickness, and the third thickness is a sum of the first thickness and the second thickness.

Based on the foregoing technical solution, in this application, the etching depth may exceed the thickness of the fourth thin film, and etching is performed in the chip substrate. Therefore, the metal thin film may be thicker, and the fourth thin film may be thinner, so that a thickness of the entire chip can be reduced, subsequent packaging of the chip is facilitated, and difficulty of a subsequent process of the chip can be reduced.

In a possible implementation, the chip substrate is a thinned substrate.

Based on the foregoing technical solution, the chip substrate may be thinned in consideration of difficulty of a packaging process and a requirement for a chip volume.

In a possible implementation, that the fourth thin film of the second thickness is deposited on the back surface of the chip substrate includes: a fifth thin film is deposited on the back surface of the chip substrate.

In a possible implementation, that the fourth thin film of the second thickness is deposited on the back surface of the chip substrate includes: a fifth thin film is deposited on the back surface of the chip substrate, and a sixth thin film is deposited on the fifth thin film, where the fifth thin film and the sixth thin film are used as a hard mask (hard mask) layer and/or a polishing stop layer.

For example, a polishing rate of the fifth thin film and/or the sixth thin film may be less than a polishing rate of the metal thin film.

Based on the foregoing technical solution, in this application, two layers of dielectric thin films may be deposited. For example, that the polishing rate of the fifth thin film and/or the sixth thin film is less than the polishing rate of the metal thin film may alternatively be understood as that an entire polishing speed of the chip may be controlled by using the fifth thin film and/or the sixth thin film. For another example, to evaporate a photoresist excessively fast in an etching process, the fifth thin film and/or the sixth thin film may be used as a hard mask layer, to ensure an etching depth. It should be understood that a photoresist image may be transferred to a hard mask, and then a final pattern etching is transferred to the substrate by using the hard mask.

In a possible implementation, the chip substrate is a silicon substrate.

In a possible implementation, a thickness of the third thin film is greater than 9000 A.

In a possible implementation, a pattern photoetched on the back surface of the chip substrate includes a pattern of a metal electrode and an auxiliary pattern, where the auxiliary pattern is used to flatten a surface of the third thin film in a polishing process.

Based on the foregoing technical solution, a thick metal electrode can be manufactured by using the chip metallization process provided in this application, to improve a power supply capability of the chip.

According to a second aspect, a chip metallization method is provided. It should be understood that, for beneficial effects corresponding to the chip metallization method provided in this application, refer to the implementations of the chip structure corresponding to the first aspect. Details are not described again.

The method includes: etching a back surface of a chip substrate, where a thickness of the chip substrate is a first thickness, and an etching depth is less than the first thickness; depositing a first thin film on the etched chip substrate, where the first thin film is a dielectric material; depositing a second thin film on the first thin film, where the second thin film is a barrier layer material; and depositing a third thin film on the second thin film, where the third thin film is a metal material, and the third thin film is embedded into the chip substrate.

In a possible implementation, before etching the back surface of the chip substrate, the method further includes:
depositing a fourth thin film of a second thickness on the back surface of the chip substrate, where the fourth thin film is the dielectric material; and etching the chip substrate includes: etching the back surface that is of the etched chip substrate and on which the fourth thin film is deposited, where the etching depth is greater than the second thickness and less than a third thickness, and the third thickness is a sum of the first thickness and the second thickness.

In a possible implementation, the chip substrate is a thinned substrate.

In a possible implementation, depositing the fourth thin film of the second thickness on the back surface of the chip substrate includes: depositing a fifth thin film on the back surface of the chip substrate.

In another possible implementation, depositing the fourth thin film of the second thickness on the back surface of the chip substrate includes: depositing a fifth thin film on the back surface of the chip substrate; and depositing a sixth thin film on the fifth thin film, where the fifth thin film and the sixth thin film are used as a hard mask (hard mask) layer and/or a polishing stop layer.

For example, a polishing rate of the fifth thin film and/or the sixth thin film may be less than a polishing rate of the metal thin film.

In a possible implementation, the chip substrate is a silicon substrate, or the chip substrate is a gallium arsenide substrate, or the chip substrate is an indium phosphide substrate, or the like. A material of the chip substrate is not limited in this application.

In a possible implementation, a thickness of the third thin film is greater than 9000 A.

In a possible implementation, before etching the back surface of the chip substrate, the method further includes: performing photoetching on the back surface of the chip substrate, where a pattern photoetched on the back surface of the chip substrate includes a pattern of a metal electrode and an auxiliary pattern, and the auxiliary pattern is used to flatten a surface of the third thin film in a polishing process.

According to a third aspect, a chip system is provided. The chip system includes a plurality of chips, and at least one of the plurality of chips is the chip according to any one of the possible implementations of the first aspect.

According to a fourth aspect, an electronic device is provided. The electronic device includes a circuit substrate, and the circuit substrate includes the chip according to any one of the possible implementations of the first aspect.

### BRIEF DESCRIPTION OF DRAWINGS

FIG. 1 is a diagram of a structure of a chip formed by using a conventional chip metallization process according to this application;
FIG. 2 is a schematic flowchart of a chip metallization method 200 according to this application;
FIG. 3(a) to FIG. 3(h) are a diagram of a metallization process and a change of a structure of a chip according to this application; and
FIG. 4 is a diagram of a chip integration architecture to which this application is applicable.

### DESCRIPTION OF EMBODIMENTS

The following describes technical solutions of embodiments in this application with reference to accompanying drawings.

To facilitate understanding of the technical solutions of this application, the following first briefly describes some terms related to a semiconductor process in this application.

### 1. Thin film deposition technology

Thin film deposition is an indispensable part in a semiconductor process. A thin film is deposited on a surface of a semiconductor, and then a specific circuit pattern is formed by using a photoetching process, to accurately control performance and a characteristic of an electronic device. Conventional thin film deposition processes mainly include chemical vapor deposition (chemical vapor deposition, CVD) and physical vapor deposition (physical vapor deposition, PVD). The CVD process includes atomic layer deposition (atomic layer deposition, ALD) and plasma enhanced chemical vapor deposition (plasma enhanced chemical vapor deposition, PECVD). The PVD deposition technology includes a magnetron sputtering method, an electron beam deposition method, and thermal evaporation.

### 2. Thinning

In a back-end-of-line process phase, a circuit has been deployed on a front surface of a wafer (wafer), and a back surface needs to be thinned before subsequent scribing, press-welding, and packaging, to reduce a package mounting height and a chip package volume, so that a thermal diffusion efficiency, electrical performance, and mechanical performance of a chip are improved, and a scribing processing amount is reduced. A back surface grinding process has advantages of high efficiency and low costs, and has replaced conventional wet etching and ion etching processes as the most important back surface thinning technology.

At present, grinding processes that have been successfully used in silicon wafer preparation include rotary table grinding, silicon wafer rotary grinding, double-sided grinding, and the like. With further improvement of surface quality requirements of monocrystalline silicon wafers, new grinding technologies are continuously proposed, such as TAIKO grinding, chemical mechanical grinding, polishing grinding, and planetary plate grinding.

### 3. Polishing

After a wafer is thinned, there are many defects on a surface of the wafer, and there are many tiny cracks and stresses inside the wafer. Therefore, consistency, uniformity, and surface roughness of polishing are very important for a chip. In addition, a perfect reflective surface can be implemented by using a polishing process. A chemical mechanical polishing (chemical mechanical polishing, CMP) process is one of key technologies for surface processing of a wafer of a semiconductor, and is also referred to as chemical mechanical planarization (chemical mechanical planarization, CMP).

Chemical mechanical polishing is a process that combines mechanical friction and chemical corrosion. (1) Chemical corrosion-polishing solution: First, an oxidant and a catalyst in a polishing solution between a surface of a workpiece and a polishing pad chemically react on a surface material of the workpiece, and a chemically reacted thin film is generated on the surface of the workpiece. (2) Mechanical friction-polishing pad: Then, abrasive particles in the polishing solution and the polishing pad made of a polymer material remove the chemically reacted thin film through mechanical action, so that the surface of the workpiece is exposed again, and then a chemical reaction is performed. The entire process is a process in which chemical action and mechanical action are performed alternately, to finally complete polishing on the surface of the workpiece. An overall polishing rate may be controlled by using a thin film with a low polishing rate.

### 4. Cleaning

Cutting, grinding, and polishing are indispensable steps for producing a monocrystal in a laser device. In these three steps, lubricating oil, antirust oil, and other greases are used to ensure normal operation of a machine. Generally, rosin, paraffin, or a mixture of rosin and paraffin are used as an adhesive to fasten a monocrystal. Various abrasives are used for grinding of silicon wafers, and the abrasives usually are an artificial or natural diamond sand powder like silicon carbide (SiC) and aluminum trioxide (Al₂O₃). Magnesium oxide (MgO), silicon dioxide (SiO₂), chromium sesquioxide (Cr₂O₃), and the like are commonly used polishing powders. In the three steps of cutting, grinding, and polishing, tap water is usually used for flushing for cost and convenience. Common tap water generally contains various elements such as gold, silver, copper, iron, nickel, potassium, sodium, calcium, magnesium, fluorine, chlorine, oxygen, and hydrogen. In addition, these elements also exist in the air and a production environment. Therefore, grease, metal elements, dust, and the like are often attached to a surface of the monocrystal after cutting, grinding, and polishing.

Because almost all working environments and process operations may cause contamination on the surface of the monocrystal, ultra-clean workshops or ultra-clean workbenches are widely used in modern semiconductor device production. Generally, an entire chip process needs to be performed in a class 100 ultra-cleanroom to minimize dust and impurities. In addition, ultra-purity or high-purity chemical reagents and high-purity water are used to perform strict chemical cleaning on silicon wafers, production appliances, and metal materials. In a cleaning process, the impurities and the chemical reagents may react chemically and dissolve, to be separated from epitaxial wafers or components that are under cleaning. In addition, the epitaxial sheets or the components are washed with cold and hot pure water to ensure that the surface is completely clean. Stains on the surface of the components greatly affect each process in a production process, and may be accumulated gradually. As a result, performance of the components deteriorates, reliability deteriorates, and finally the components may fail completely.

### 5. Photoetching

In a semiconductor process, a discrete device is determined and different regions in an integrated circuit are determined. For example, a light-emitting surface, an electrode pattern, and a current injection region are all implemented by using a photoetching process. Therefore, photoetching is an extremely important single process. Photoetching is to transfer a design achievement on a mask (which may also be referred to as a photoetching plate) to a material layer that covers a component. Transfer of a pattern may be implemented by using an etching process of selectively removing a non-mask part. For example, a layer of dielectric film may be generated by using PECVD, which is an early preparation for photoetching, and a mask material is usually silicon dioxide (SiO₂) or silicon nitride (SiNₓ). A general photoetching process is as follows: A surface of a wafer is first processed, then a photoresist is spin-coated, then pre-baking is performed, then alignment exposure and development are performed, and finally hard baking is performed.

### 6. Etching

An etching technology is classified into dry etching and wet etching according to different processes. In most cases, dry etching is used to prepare a surface. In comparison with wet etching, dry etching has three advantages: An etching depth is easy to control, an etching rate can be adjusted, and impact of an external environment can be avoided. Wet etching mainly achieve requirements based on a chemical reaction between a solution and an etched part. Currently, wet etching is seldom used, and has been gradually replaced by dry etching. However, wet etching has outstanding application in aspects such as drifting away silicon dioxide, removing residues, and peeling off electrodes.

### 7. Chip metallization process

A metallization (metallization) process is also referred to as a metal forming process or a metal wiring process. Semiconductors implement circuit operation through connections between layers, and this requires a "metallization process". Generally, a connection line is required to receive electric energy from the outside, so that signals between components are not mixed together.

In a chip manufacturing process, a metal thin film may be deposited on an insulation dielectric thin film, and a metal connection line is embedded in the middle of the insulation dielectric layer to form an electrical connection. Generally, in a metallization process of a back surface of a chip substrate, the deposited dielectric layer is etched, and then the metal thin film is deposited. It may also be understood that a thickness of the metal thin film is positively correlated with a thickness of the dielectric layer. Consequently, a deposited metal may be embedded in the dielectric layer. Therefore, if the thickness of the metal layer of the chip needs to be increased, the thickness of the dielectric layer needs to be increased. However, if the dielectric layer is excessively thick, a large thin film stress is generated, causing a wafer to warp. This increases difficulty of a subsequent chip process, and in some cases, and affects overall performance of the chip.

In view of this, this application provides a chip metallization method, to increase a thickness of a metal layer on a back surface of a chip substrate, reduce impact of a thickness of a dielectric layer on chip performance, and improve power supply performance of a chip.

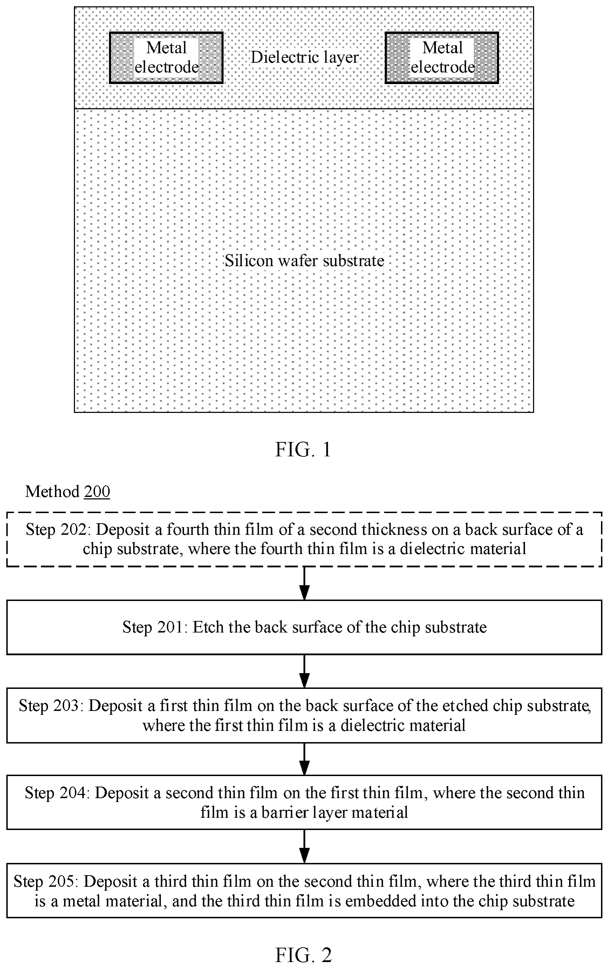

FIG. 2 is a schematic flowchart of a chip metallization method 200 according to this application. As shown in FIG. 2, the method includes the following steps.

Step 201: Etch a back surface of a chip substrate.

It should be understood that a person skilled in the art may distinguish between a back surface and a front surface of a chip substrate. For example, the front surface of the chip substrate is used to dispose a material of a designed chip structure. It may also be understood that the front surface of the chip substrate is generally used to dispose a functional material, and the back surface of the chip substrate is generally not used to dispose a functional material.

In a possible implementation, before a back surface of a chip is etched, photoetching may be further performed on the back surface of the chip. It should be understood that a pattern of a metal electrode may be made by using a photoetching process. In this application, an auxiliary pattern may be further made during photoetching. When the chip is subsequently polished, because a polishing rate of a metal material is different from a polishing rate of a surrounding dielectric thin film, and an area of the metal electrode is small, the auxiliary pattern may be added during photoetching, to increase an area of the metal material, so that a polishing rate of the metal electrode is uniform, and flatness of a surface of the metal thin film is improved.

In this application, a thickness of the chip substrate is a first thickness. For example, the chip substrate is a silicon (Si) substrate. For another example, the chip substrate is gallium arsenide (GaAs). For another example, the chip substrate is indium phosphide (InP). The chip substrate is not limited in this application. An etching depth is less than the first thickness.

In a possible implementation, the chip substrate is a thinned chip substrate.

Optionally, before step 201, the method further includes step 202: deposit a fourth thin film of a second thickness on the back surface of the chip substrate, where the fourth thin film is a dielectric material.

In this application, the fourth thin film is a dielectric material. For example, the fourth thin film may be an oxide thin film. For another example, the fourth thin film is a nitride thin film. A specific material of the dielectric thin film is not limited in this application. A person skilled in the art may flexibly determine the material of the dielectric thin film based on an actual situation.

In a possible implementation, the fourth thin film is a dielectric thin film. For example, the fourth thin film is an oxide thin film.

In another possible implementation, the fourth thin film in step 202 may alternatively be understood as two layers of thin films. For example, a fifth thin film may be first deposited on the back surface of the chip substrate, and then a sixth thin film continues to be deposited on the fifth thin film. The fifth thin film and the sixth thin film are a hard mask layer and/or a polishing stop layer. For example, a polishing rate of the sixth thin film is less than a polishing rate of the metal thin film. When the metal thin film is subsequently polished, to control a thickness of polishing, a layer of protective thin film may be deposited in advance to protect the chip. The protective layer is characterized by a very small polishing rate, and the polishing rate is at least less than the polishing rate of the metal thin film. In this way, the polishing rate can be controlled. For another example, because a photoresist evaporates excessively fast in an etching process, the fifth thin film and/or the sixth thin film may further be used as a hard mask layer, to ensure an etching depth. It should be understood that a photoresist image may be transferred to a hard mask, and then a final pattern etching is transferred to the substrate by using the hard mask.

In the foregoing implementation, an etching depth is greater than the first thickness and less than a third thickness, where the third thickness is a sum of the first thickness and the second thickness. It may also be understood that, in this application, the dielectric layer is etched during etching, and etching is performed in the chip substrate. It should be understood that, in this implementation, because the fourth thin film of the second thickness is deposited, the etching depth may be greater than the thickness of the chip substrate.

It should be noted that, according to the method provided in this application, in this application, during etching, the etching depth exceeds the thickness of the deposited fourth thin film. In other words, the dielectric layer is etched, and the chip substrate is etched. In addition, the thickness of the deposited fourth thin film may be less than 9000 A. In comparison with the method in the conventional technology, the thickness of the dielectric layer can be reduced, difficulty of a subsequent chip process can be reduced, and overall performance of the chip can be improved.

Step 203: Deposit a first thin film on the etched chip substrate, where the first thin film is a dielectric material.

For example, the first thin film is an oxide thin film. For example, a thin film material having good adhesion to the chip substrate may be used, so that inside of an etched channel and a surface of the substrate can be covered.

Step 204: Deposit a second thin film on the first thin film, where the second thin film is a barrier layer material.

In this application, for example, the second thin film is used to block diffusion of the metal material.

For example, TaN/Ta or TiN/Ti may be deposited based on a physical vapor deposition method or an atomic layer deposition method, to form a metal barrier layer. The barrier layer is used to block diffusion of a subsequently deposited metal material.

It should be understood that a sum of the thickness of the first thin film and the thickness of the second thin film that are deposited in this application is less than the etching depth. In other words, a sum of the thickness of the first thin film and the thickness of the second thin film does not exceed the etching depth. In this way, the third thin film that is subsequently deposited can be embedded into the chip substrate.

Step 205: Deposit a third thin film on the second thin film, where the third thin film is a metal material, and the third thin film is embedded into the chip substrate.

For example, metals such as copper (Cu), cobalt (Co), and tungsten (W) may be deposited based on an electron beam deposition method or a physical vapor deposition method.

It should be understood that, according to the process method provided in this application, a thickness of the metal thin film may be greater than 9000 A.

Based on the foregoing technical solution, in this application, the dielectric layer does not need to be deposited, and the substrate on the back surface of the chip may be directly etched, so that the first thin film, the second thin film, and the third thin film that are subsequently deposited may all be embedded into the chip substrate, where the third thin film is a metal layer. In other words, in this application, etching is performed in the chip substrate. Because the chip substrate is usually thick, a thickness of the third thin film may be flexibly controlled by controlling thicknesses of the first thin film and the second thin film. In this way, a thickness of a metal layer can be increased, and a thickness of the dielectric layer can be reduced as much as possible. According to the solutions of this application, impact of an excessively thick dielectric layer on chip performance can be reduced, power supply performance of the chip can be improved, and overall performance of the chip is improved.

In addition, a thermal conductivity of metal in the chip is usually higher than that of the chip substrate, and a metal electrode may be considered as a heat source. In this application, the metal electrode may be embedded into the chip substrate, so that a heat dissipation capability of the chip can be improved. In addition, in this application, impact of the thickness of the dielectric layer on chip performance is further avoided, so that a thickness of the entire chip can be reduced, subsequent packaging of the chip is facilitated, and difficulty of a subsequent process of the chip can be reduced.

It should be noted that a large quantity of technological processes are involved in the chip metallization process. This application merely shows a main technological process or an improved technological process. For another necessary technological process, refer to an existing process. For example, an anti-reflection layer further needs to be prepared, to reduce reflection at the bottom of the photoresist, improve imaging contrast, improve linewidth uniformity, and the like. Details are not described again.

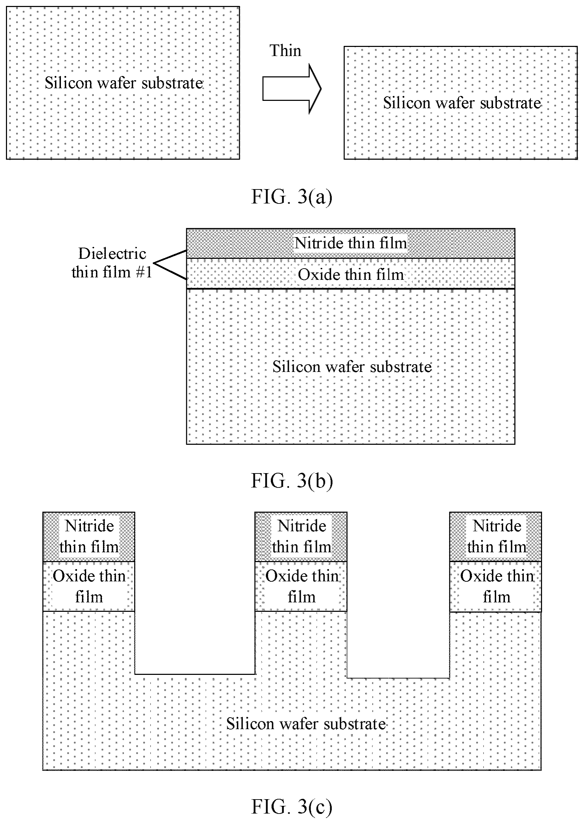

To understand the technical solutions of this application more clearly, FIG. 3(a) to FIG. 3(h) show a main process and a change of a structure of a chip in a metallization process provided in this application. In this example, an example in which a chip substrate is a silicon substrate is used for description. As shown in FIG. 3(a) to FIG. 3(h), the process includes the following steps.

### Step 1: Thin and flatten a back surface of a silicon wafer.

As shown in FIG. 3(a), the back surface of the silicon wafer may be first thinned and flattened by using a thinning process and a polishing process.

### Step 2: Deposit a dielectric thin film #1.

As shown in FIG. 3(b), for example, an insulation dielectric thin film may be deposited on the back surface of the thinned chip substrate based on a PECVD method. For example, the thin film may be an oxide thin film.

Optionally, in this application, in step 2, another layer of insulation dielectric thin film may be deposited on the oxide thin film. For example, the thin film may be a nitride thin film. For another example, the thin film may still be an oxide thin film. A polishing rate of the nitride is less than a polishing rate of a metal thin film deposited in a subsequent process. When the metal thin film is subsequently polished, to control a thickness of polishing, a layer of protective thin film may be deposited in advance to protect the chip. The protective layer is characterized by a very small polishing rate, and the polishing rate is at least less than the polishing rate of the metal thin film. It may also be understood that a polishing rate is controlled by using a deposited sixth thin film.

The deposited dielectric thin film #1 in this application may be used as a hard mask layer and/or a polishing stop layer.

### Step 3: Photoetch, etch, and clean.

For example, a pattern is made by using a photoetching process, then a trench is etched by using a dry etching process, and the chip is cleaned.

Optionally, in this application, an auxiliary pattern may be further made when the pattern of the metal electrode is made through photoetching. The auxiliary pattern is used to make a polishing rate of the metal electrode more uniform when the metal electrode is subsequently polished.

As shown in FIG. 3(c), in the method in this application, during etching, the dielectric thin film deposited in step 2 is etched, and etching is performed in the silicon substrate, so that a subsequently deposited metal material may be thick, and a thickness of the dielectric thin film does not need to be increased.

### Step 4: Deposit a dielectric thin film #2.

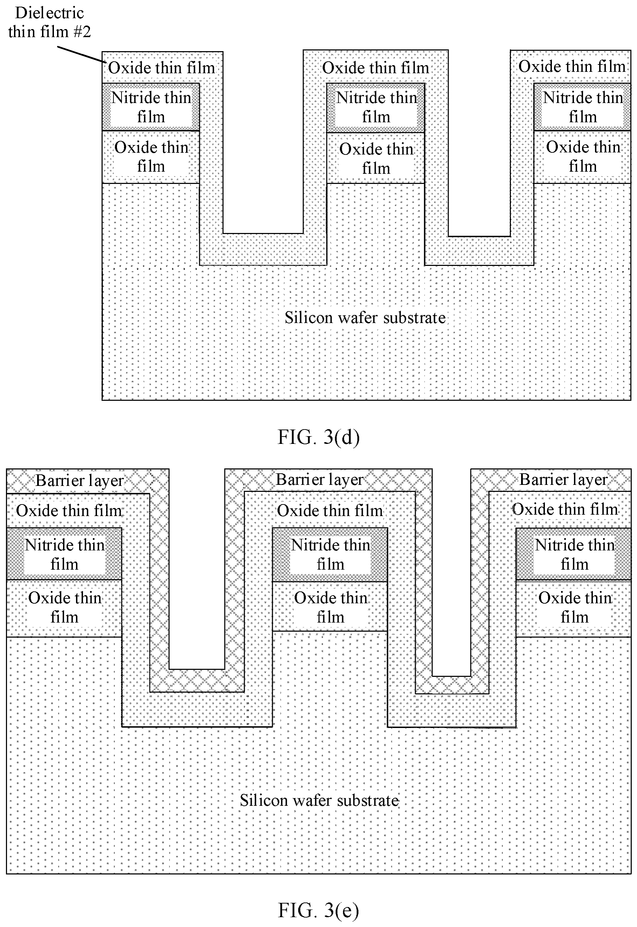

As shown in FIG. 3(d), for example, a layer of oxide thin film may continue to be deposited. A thin film material having good adhesion to the chip substrate may be used, so that inside of an etched channel and a surface of the substrate can be covered.

### Step 5: Deposit a metal barrier layer thin film.

As shown in FIG. 3(e), to prevent diffusion of a subsequently deposited metal material, TaN/Ta or TiN/Ti may be deposited to block diffusion of the metal layer.

### Step 6: Deposit a metal thin film.

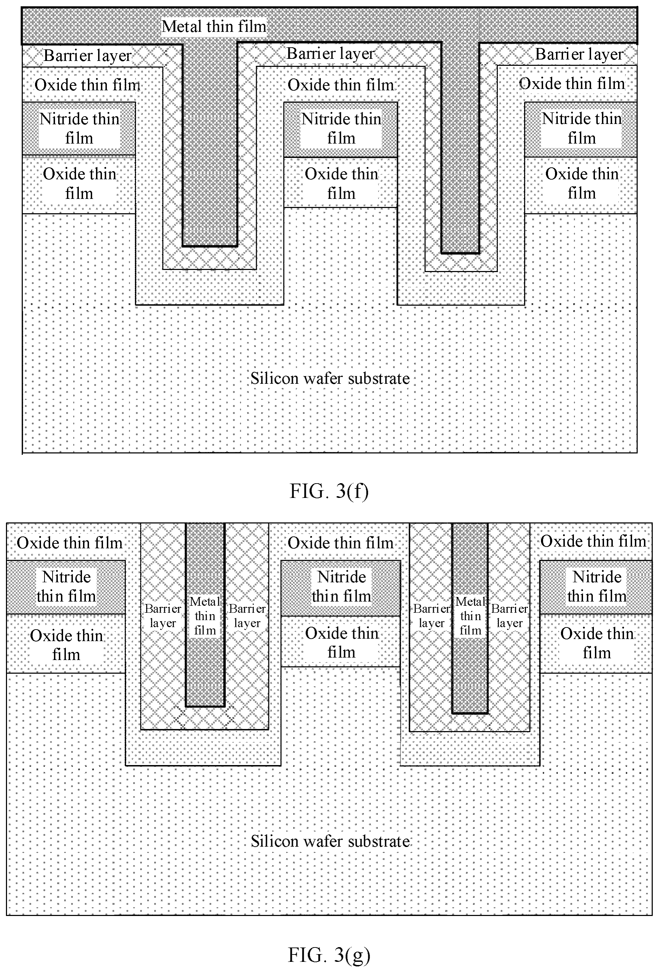

As shown in FIG. 3(f), for example, metals such as copper (Cu), cobalt (Co), and tungsten (W) may be deposited based on an electron beam deposition method or a physical vapor deposition method.

### Step 7: Polish.

As shown in FIG. 3(g), for example, a trench metal and the metal barrier layer of the silicon wafer on the back surface may be polished based on a CMP method.

### Step 8: Deposit a coverage layer.

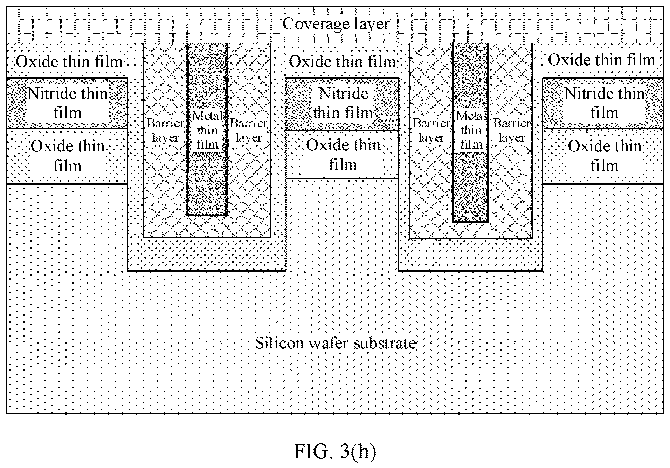

As shown in FIG. 3(h), for example, a nitride or carbon nitride coverage layer may be deposited based on a CVD method, to protect the metal electrode.

For example, FIG. 3(h) shows a structure of a chip obtained according to the chip metallization method in this application. As shown in FIG. 3(h), the chip includes: the silicon wafer substrate, the dielectric thin film #1 (there may be one or two layers, for example, a first layer of oxide thin film and a second layer of nitride thin film), the dielectric thin film #2 (for example, a third layer of oxide thin film), the barrier layer, and the metal thin film. It can be learned from FIG. 3(h) that an etching depth in this application is greater than a thickness of the dielectric thin film #1, or it may be understood that etching is performed in the silicon wafer substrate in this application, so that the metal thin film is embedded in the silicon wafer substrate.

It can be learned from FIG. 1 that only one side of the metal electrode is adjacent to the chip substrate. However, it can be learned from FIG. 3(h) of this application that three sides of the metal electrode are closely adjacent to the chip substrate. Because the metal electrode is a heat source, the chip structure provided in this application can improve a heat dissipation capability of the chip.

In a possible implementation, that the dielectric thin film #1 is deposited on the back surface of the chip substrate includes: An oxide thin film is deposited on the back surface of the chip substrate.

In another possible implementation, that the dielectric thin film #1 is deposited on the back surface of the chip substrate includes: A fifth thin film is deposited on the back surface of the chip substrate, and a sixth thin film is deposited on the fifth thin film, where a polishing rate of the sixth thin film is less than a polishing rate of the metal thin film. For example, both the fifth thin film and the sixth thin film are oxide thin films. For another example, both the fifth thin film and the sixth thin film are nitride thin films. For another example, the fifth thin film is an oxide thin film, and the sixth thin film is a nitride thin film. The fifth thin film and the sixth thin film are a hard mask layer and/or a polishing stop layer.

In a possible implementation, a thickness of the metal thin film is greater than 9000 A.

In a possible implementation, the photoetched pattern includes a pattern of a metal electrode and an auxiliary pattern. The auxiliary pattern is used to make a polishing rate of the metal thin film uniform in a polishing process, to improve flatness of a surface of the metal thin film.

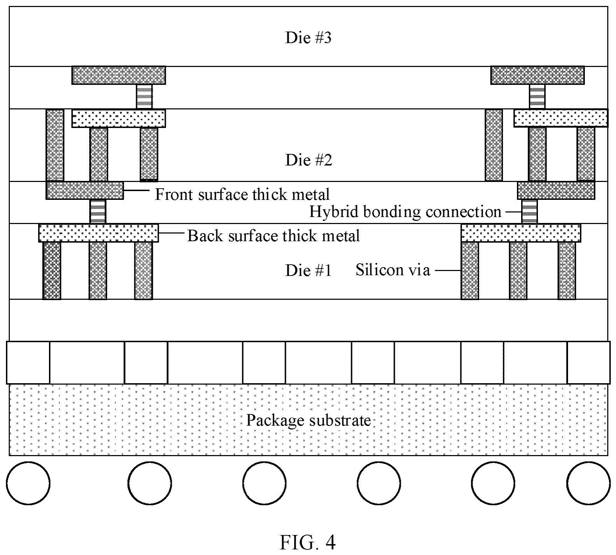

FIG. 4 is a diagram of a chip integration architecture to which a solution provided in this application is applicable. A three-dimensional integrated device is used as an example. FIG. 4 shows an architecture in which three dies (dies) are stacked. A solution of manufacturing an ultra-thick metal may be implemented on a back surface of a die. A die #1 is used as an example for description. Metal wiring on a back surface of the die may be implemented after the back surface of the die is thinned, so that the metal wiring can be connected to a silicon via, to implement electrical conduction between a front surface and the back surface. Then, a connection between the die #1 and a die #2 may be implemented on the front surface and the back surface of the die by using a hybrid bonding process. Similarly, a die #3 and more stacked dies may be connected. Finally, the dies are sliced and packaged into a chip product.

In the architecture shown in FIG. 4, based on the solution provided in this application, a power supply capability and a heat dissipation capability of the chip product can be improved, and packaging difficulty can be reduced.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of the present invention.

## Claims

1. A chip, comprising: a chip substrate, a first thin film, a second thin film, and a third thin film, wherein
a back surface of the chip substrate is etched, a thickness of the chip substrate is a first thickness, and an etching depth is less than the first thickness; the first thin film is deposited on the back surface of the etched chip substrate, and the first thin film is a dielectric material; the second thin film is deposited on the first thin film, and the second thin film is a barrier layer material; and the third thin film is deposited on the second thin film, the third thin film is a metal material, and the third thin film is embedded into the chip substrate.

2. The chip according to claim 1, wherein a fourth thin film is deposited on the back surface of the chip substrate, the fourth thin film is the dielectric material, and a thickness of the fourth thin film is a second thickness;
that the back surface of the chip substrate is etched comprises:
the chip substrate on which the fourth thin film is deposited is etched; and
that the first thin film is deposited on the back surface of the etched chip substrate comprises:
the first thin film is deposited on the back surface that is of the etched chip substrate and on which the fourth thin film is deposited, wherein the etching depth is greater than the second thickness and less than a third thickness, and the third thickness is a sum of the first thickness and the second thickness.

3. The chip according to claim 2, wherein that the fourth thin film of the second thickness is deposited on the back surface of the chip substrate comprises:
a fifth thin film is deposited on the back surface of the chip substrate, and a sixth thin film is deposited on the fifth thin film, wherein the fifth thin film and the sixth thin film are used as a hard mask layer and/or a polishing stop layer.

4. The chip according to any one of claims 1 to 3, wherein the chip substrate is a thinned substrate.

5. The chip according to any one of claims 1 to 4, wherein the chip substrate is a silicon substrate.

6. The chip according to any one of claims 1 to 5, wherein a thickness of the third thin film is greater than 9000 A.

7. The chip according to any one of claims 1 to 6, wherein a pattern photoetched on the back surface of the chip substrate comprises a pattern of a metal electrode and an auxiliary pattern, and the auxiliary pattern is used to flatten a surface of the third thin film in a polishing process.

8. A chip metallization method, comprising:
etching a back surface of a chip substrate, wherein a thickness of the chip substrate is a first thickness, and an etching depth is less than the first thickness;
depositing a first thin film on the etched chip substrate, wherein the first thin film is a dielectric material;
depositing a second thin film on the first thin film, wherein the second thin film is a barrier layer material; and
depositing a third thin film on the second thin film, wherein the third thin film is a metal material, and the third thin film is embedded into the chip substrate.

9. The method according to claim 8, wherein before etching the back surface of the chip substrate, the method further comprises:
depositing a fourth thin film of a second thickness on the back surface of the chip substrate, wherein the fourth thin film is the dielectric material; and
etching the chip substrate comprises:
etching the back surface that is of the etched chip substrate and on which the fourth thin film is deposited, wherein the etching depth is greater than the second thickness and less than a third thickness, and the third thickness is a sum of the first thickness and the second thickness.

10. The method according to claim 9, wherein depositing the fourth thin film of the second thickness on the back surface of the chip substrate comprises:
depositing a fifth thin film on the back surface of the chip substrate; and
depositing a sixth thin film on the fifth thin film, wherein
the fifth thin film and the sixth thin film are used as a hard mask layer and/or a polishing stop layer.

11. The method according to any one of claims 8 to 10, wherein the chip substrate is a thinned substrate.

12. The method according to any one of claims 8 to 11, wherein the chip substrate is a silicon substrate.

13. The method according to any one of claims 8 to 12, wherein a thickness of the third thin film is greater than 9000 A.

14. The method according to any one of claims 8 to 13, wherein before etching the back surface of the chip substrate, the method further comprises:
performing photoetching on the back surface of the chip substrate, wherein a photoetched pattern comprises a pattern of a metal electrode and an auxiliary pattern, and the auxiliary pattern is used to flatten a surface of the third thin film in a polishing process.

15. An electronic device, wherein the electronic device comprises a circuit substrate, and the circuit substrate comprises the chip according to any one of claims 1 to 7.
